# EUROPEAN PATENT APPLICATION

(11) **EP 2 772 330 A1**
(43) Date of publication of application: **03.09.2014**
(21) Application number: 12865072.8
(22) Date of filing: 27.11.2012
(51) Int. Cl.: B23B 27/14, B23B 27/20, B23B 51/00, B23C 5/16

(54) **DIAMOND-COATED TOOL**

(30) Priority: 10.01.2012 JP 2012002149
(71) Applicant: Sumitomo Electric Hardmetal Corp., Itami-shi, Hyogo 664-0016 (JP)
(72) Inventor: MEGURO, Kiichi, Itami-shi Hyogo 664-0016 (JP)
(74) Representative: Boult Wade Tennant
(86) International application number: PCT/JP2012/080582
(87) International publication number: WO 2013/105348

(57) **Abstract**

A diamond coated tool according to the present invention includes a base material, and a diamond layer coating a surface of the base material, the diamond layer containing a diamond, 1.0 × 10¹⁸ to 1.0 × 10²² atoms/cm³ of boron, and 1.0 × 10¹⁷ to 1.0 × 10²¹ atoms/cm³ of nitrogen.

## Description

### TECHNICAL FIELD

The present invention relates to a diamond coated tool in which a surface of a base material is coated with a diamond layer.

### BACKGROUND ART

Diamond has the highest hardness of the existing substances, and has long found applications in cutting tools, grinding tools, wear-resistant tools, and the like, in the forms of natural diamond, superhigh pressure sintered diamond, and the like. Since the establishment of the technology of manufacturing diamond thin films by chemical vapor deposition (CVD) in the 1980's, a relatively high degree of freedom of shape has been achieved, and technical development has progressed with a view toward expanding the application to cutting tools having complicated curved surfaces such as drills and end mills, and wear-resistant tools such as drawing dies. In recent years, demands have been expanding for use in machining fiber reinforced plastics (FRPs) that are in increasing demand in aircraft industry, composite structure materials of FRPs and metals that are easily adhered during machining, such as Al, Ti and the like, and difficult-to-cut materials such as non-metals, glasses, and ceramics.

It has been found that the use of a polycrystalline diamond-coated tool for the above-mentioned difficult-to-cut material or wear-resistant application leads to a dramatically improved lifetime, as compared to a conventional uncoated cemented carbide tool, a ceramic-coated tool, or the like. Even when the coating layer is made of a diamond, however, wear or defects may develop during machining, depending on the workpiece or the machining method.

Several proposals have been made to solve this problem, and in Japanese Patent Laying-Open No. 2006-150572 (PTD 1), for example, boron oxide is formed on a surface of a diamond layer by doping the diamond layer with boron to improve oxidation resistance. Japanese Patent Laying-Open No. 2009-280421 (PTD 2) also discloses an example in which the breaking strength of a diamond layer is improved by doping the diamond layer with boron to prevent microchipping.

### CITATION LIST

### PATENT DOCUMENT

- PTD 1:: Japanese Patent Laying-Open No. 2006-150572
- PTD 2:: Japanese Patent Laying-Open No. 2009-280421

### SUMMARY OF INVENTION

### TECHNICAL PROBLEM

The present inventor found that when boron is added into a diamond layer using a conventional method as described in PTD 1 or 2, oxidation resistance and breaking strength are improved, while the adhesion between the diamond layer and the base material is often lower than that obtained without the addition of boron.

As a result of a close investigation of this cause, it was found that this is because when boron is added into a diamond layer, the crystal lattice constant, the thermal expansion coefficient, the crystal grain size, or the orientation of the polycrystal of the diamond changes significantly as compared to the case without the addition of boron, which results in an increased residual stress in the diamond layer.

Thus, the present inventor manipulated the growth conditions for a diamond layer to improve the adhesion between the diamond layer and a base material, and consequently found that when certain conditions are used, a residual stress close to that obtained without the addition of boron can be achieved. It was revealed, however, that the use of such conditions have many constraints, such as an extreme degree of deterioration of the crystallinity of the diamond layer, namely, wear resistance, and an inability to achieve an industrially practical growth rate of the diamond layer.

The present invention was made in view of the foregoing circumstances, and an object of the invention is to provide a diamond coated tool that, even with the addition of boron into the diamond layer, can possess the characteristics of a diamond layer obtained with the addition of boron, while ensuring adhesion to the base material and productivity equal to or higher than those of the diamond layer obtained without the addition of boron.

### SOLUTION TO PROBLEM

The present inventor investigated a residual stress after the growth of a diamond layer, which determines the adhesion between the diamond layer and a base material, and consequently ascertained that the diamond layer is peeled from the base material when the residual stress of the diamond layer exceeds a certain value. It was found that particularly when a cemented carbide is used as the base material in the diamond coated tool to be achieved by the present invention, a compressive stress remains in the diamond layer after the growth of the diamond layer, and a tensile stress remains in the cemented carbide as the base material. Furthermore, when growth conditions for the diamond layer other than the addition of boron into the diamond layer are the same as those without the addition of boron, the diamond layer obtained with the addition of boron has an increased residual compressive stress in the diamond layer, as compared to the diamond layer obtained without the addition of boron. Consequently, it was found that this causes the diamond layer to be more easily peeled off, immediately after the growth of the diamond layer or during machining.

On the other hand, it was also found that while it is necessary to add a gas containing boron during the growth of a diamond layer in order to add boron into the diamond layer, the crystallinity of the diamond changes due to the influence of the boron in a vapor phase, which causes an increase in residual stress.

The present inventor conducted a further study based on the findings as described above, and consequently found that the addition of nitrogen with boron can reduce residual stress at the time of the addition of boron, and conducted a further study based on this finding to thereby accomplish the present invention.

That is, a diamond coated tool according to the present invention includes a base material and a diamond layer coating a surface of the base material, the diamond layer containing a diamond, 1.0×10¹⁸ to 1.0×10²² atoms/cm³ of boron, and 1.0 × 10¹⁷ to 1.0 × 10²¹ atoms/cm³ of nitrogen.

The diamond layer preferably has a residual compressive stress of 500 to 2500 MPa on a surface thereof according to X-ray stress measurement, and the diamond layer preferably has a maximum particle size of 0.05 to 3 µm of diamond particles on the surface thereof.

The diamond layer preferably contains 3.0 × 10¹⁹ to 3.0 × 10²¹ atoms/cm³ of boron, and preferably contains 1.0 × 10¹⁸ to 1.0 × 10²⁰ atoms/cm³ of nitrogen.

The diamond layer preferably has a residual compressive stress of 800 to 2000 MPa on the surface thereof according to X-ray stress measurement, and the base material is preferably made of a cemented carbide.

The surface of the base material preferably has an arithmetic mean roughness Ra of 0.1 to 10 µm and a mean length RSm of roughness profile elements of 1 to 100 µm, and the diamond layer preferably has a thickness of 0.1 to 30 µm.

### ADVANTAGEOUS EFFECTS OF INVENTION

By virtue of the structure as described above, the diamond coated tool according to the present invention exhibits an excellent effect of improving oxidation resistance and defect resistance with the addition of boron, while ensuring sufficient adhesion and productivity even with the addition of boron into the diamond layer, to thereby improve the tool lifetime.

### DESCRIPTION OF EMBODIMENTS

The present invention will be described in greater detail below.

### <Diamond Coated Tool>

A diamond coated tool according to the present invention includes a base material, and a diamond layer coating a surface of the base material. The diamond coated tool may include any other structural elements so long as it has these structural elements. While the surface of the base material is coated with the diamond layer in the present invention, the present invention is not limited to the case where the entire surface of the base material is coated with the diamond layer, and also includes cases where the surface of the base material is partly uncoated with the diamond layer.

The diamond coated tool according to the present invention can be used as, for example, a cutting tool such as an insert, a turning tool, a cutter, a drill, an end mill, or the like, or as a wear-resistant tool such as a die, a bending die, a drawing die, a bonding tool, or the like.

### <Diamond Layer>

The diamond layer according to the present invention is characterized in that it contains a diamond, 1.0 × 10¹⁸ to 1.0 × 10²² atoms/cm³ (not less than 1.0 × 10¹⁸ atoms/cm³ and not more than 1.0 × 10²² atoms/cm³; when a numerical value is indicated herein as such a range of values, lower limit and upper limit values are also subsumed within the range) of boron, and 1.0 × 10¹⁷ to 1.0 × 10²¹ atoms/cm³ of nitrogen.

As referred to herein, boron and nitrogen each include all the isotopes thereof, and accordingly, the boron content and the nitrogen content as mentioned above are values with all the respective isotopes being included. Since the diamond layer of the present invention therefore contains a specific amount of nitrogen with boron, it has a residual stress suppressed within a certain range, to thereby solve the problem as mentioned above due to the addition of boron. While a detailed mechanism by which this advantageous effect is demonstrated by the addition of nitrogen is unclear, it is presumed that this is because a change in the crystallinity of the diamond due to the addition of boron (the orientation, the lattice constant, or the coefficient of thermal expansion) is canceled by the addition of nitrogen.

The diamond layer of the present invention may include any other components, so long as it has the above-described structure and attains the effects of the present invention.

If the diamond layer of the present invention has a boron content (density) of less than 1.0 × 10¹⁸ atoms/cm³, sufficient oxidation resistance will not be demonstrated. On the other hand, if the boron content exceeds 1.0 × 10²² atoms/cm³, the crystallinity of the diamond will deteriorate, which causes wear resistance to decrease. A more preferred boron content is 3.0 × 10¹⁹ to 3.0 × 10²¹ atoms/cm³.

Moreover, if the diamond layer of the present invention has a nitrogen content (density) of less than 1.0 × 10¹⁷ atoms/cm³, the residual compressive stress on the diamond layer will increase, and sufficient adhesion to the base material cannot be obtained. On the other hand, if the nitrogen content exceeds 1.0 × 10²¹ atoms/cm³, the crystallinity of the diamond will deteriorate, which causes wear resistance to decrease. A more preferred nitrogen content is 1.0 × 10 ¹⁸ to 1.0 × 10²⁰ atoms/cm³.

The diamond forming the diamond layer of the present invention is in polycrystalline form, and the boron and nitrogen described above are believed to be incorporated within each crystal by substitution with carbon. The boron and nitrogen, however, may be incorporated in a crystal grain boundary of the diamond, or may be present within a crystal without substitution in the crystal lattice. That is, the boron content (boron density) and the nitrogen content (nitrogen density) in the present invention are based on the entire diamond layer, irrespective of the form in which the boron and nitrogen are incorporated.

While the boron content (density) and the nitrogen content (density) can be measured using any known measurement method, secondary ion mass spectrometry (SIMS) is particularly preferably used because it can easily measure the densities. In measurement of these densities, the measurement point for the diamond layer is not particularly limited, and may, for example, be any thickness point in a cross section of the diamond layer, or any point on the surface of the diamond layer, and the above-described effects of the present invention can be achieved if a boron content and a nitrogen content within the above-defined ranges are measured at any one measurement point.

The diamond layer of the present invention preferably has a residual compressive stress of 500 to 2500 MPa (not less than 500 MPa and not more than 2500 MPa) on the surface thereof according to X-ray stress measurement. Since the diamond layer contains the specific amounts of boron and nitrogen as defined above, the residual compressive stress on the surface can be controlled to be within this range. As compared to a diamond coated tool obtained without the addition of boron, therefore, adhesion to the base material can be maintained more reliably while improving the oxidation resistance and breaking strength.

If the residual compressive stress is less than 500 MPa, the toughness of the diamond layer will deteriorate, which easily causes chipping during machining. On the other hand, if the residual compressive stress exceeds 2500 MPa, the diamond layer shows a tendency to be easily peeled off. A more preferred residual compressive stress is 800 to 2000 MPa.

The residual compressive stress described above can be determined using X-ray stress measurement. Calculation may be performed using any known calculation method. In the present invention, when a cemented carbide (WC) is used as the base material, the sin²ψ method (ISO-inclination method) using a (311) diffraction line from diamond is preferably adopted, in order to distinguish between diffraction lines from the cemented carbide and diamond. In measurement of a residual compressive stress, if the residual compressive stress falls within the above-defined range at any one measurement point on the surface of the diamond layer, the above-described effects of the present invention can be achieved.

The diamond layer of the present invention preferably has a maximum particle size of 0.05 to 3 µm of diamond particles on the surface thereof. When the maximum particle size of the diamond particles is within this range, the above-described effects of the present invention can be advantageously achieved. If the maximum particle size is less than 0.05 µm, the wear resistance of the diamond layer may deteriorate, which causes the tool lifetime to decrease. If the maximum particle size exceeds 3 µm, the chipping resistance of the diamond layer may deteriorate. A more preferred maximum particle size is 0.2 to 1.5 µm.

As used herein, the maximum particle size of the diamond particles refers to a maximum length of diamond particles present on the outermost surface of the diamond layer, in a direction parallel to the surface thereof. This maximum length can be measured with any microscope such as a scanning electron microscope (SEM) or an optical microscope, for example.

The diamond layer of the present invention as described above preferably has a thickness of 0.1 to 30 µm. When the thickness is within this range, a diamond coated tool having both wear resistance and defect resistance can be achieved. If the thickness is less than 0.1 µm, the strength of the diamond layer may deteriorate, which causes chipping to easily occur during cutting. If the thickness exceeds 30 µm, the diamond layer may be peeled off. A more preferred thickness is 1 to 20 µm.

### <Base Material>

As the base material of the diamond coated tool of the present invention, a base material that is conventionally known as a base material for this tool can be used without particular limitation. Examples of such base materials may include cemented carbides (including, for example, a WC-based cemented carbide, and a cemented carbide containing Co in addition to WC, which may further contain a carbonitride of Ti, Ta, or Nb, for example), cermets (mainly composed of TiC, TiN, TiCN or the like), high-speed steel, tool steel, ceramics (such as titanium carbide, silicon carbide, silicon nitride, aluminum nitride, aluminum oxide, and a mixture thereof), sintered cubic boron nitride, and sintered diamond.

As the base material of the present invention, a cemented carbide is particularly preferably used among these conventionally known base materials. That is, the base material of the present invention is advantageously made of a cemented carbide. This is because the residual compressive stress of the surface of the diamond layer can thus be advantageously controlled within the above-defined range.

The surface of the base material of the present invention preferably has an arithmetic mean roughness Ra of 0.1 to 10 µm and a mean length RSm of roughness profile elements of 1 to 100 µm. As used herein, the "surface" mentioned above refers to the surface coated with the diamond layer, which is a portion forming an interface thereof with the diamond layer. Arithmetic mean roughness Ra and mean length RSm of roughness profile elements are both specified in JIS B 0601: 2001 (ISO 4287).

When arithmetic mean roughness Ra and mean length RSm of roughness profile elements of the surface of the base material of the present invention are within the above-defined ranges, adhesion between the base material and the diamond layer can be maintained more firmly, resulting in a tool having a longer lifetime.

If arithmetic mean roughness Ra is less than 0.1 µm, a so-called "anchor effect" cannot be obtained, and the peel-off of the diamond layer may be accelerated. If arithmetic mean roughness Ra exceeds 10 µm, the surface roughness of the diamond layer will deteriorate, so that chip dischargeability may deteriorate when in use as a cutting tool. A more preferred arithmetic mean roughness Ra is 0.3 to 5 µm.

On the other hand, if mean length RSm of roughness profile elements falls outside the above-defined range, the so-called anchor effect cannot be obtained in both cases, and the peel-off of the diamond layer may be accelerated. A more preferred mean length RSm of roughness profile elements is 2 to 50 µm.

As a method for measuring arithmetic mean roughness Ra and mean length RSm of roughness profile elements, an apparatus capable of conducting a parameter analysis in accordance with JIS B 0651: 2001 (ISO 3274) may be used. While stylus-type and optical (laser, interference, or the like)-type measuring apparatuses, for example, are commercially available, a laser microscope is particularly suitable for measuring the above-mentioned numerical values (surface roughness of the base material) of the present invention because it has a high spatial resolution, and allows an easy numerical analysis. As used herein, Ra and RSm represent numerical values obtained by measuring with a laser microscope having a laser wavelength of 408 nm, a horizontal spatial resolution of 120 nm, and a height resolution of 10 nm.

### <Manufacturing Method>

While the method for manufacturing the diamond coated tool of the present invention is not particularly limited, the diamond coated tool can be manufactured by, for example, forming a diamond layer on a base material using a chemical vapor deposition method.

Specifically, at the time of vapor phase growth of a diamond, a gas containing boron and a gas containing nitrogen may be introduced into the vapor phase. For example, gases such as B₂H₆ (diborane), N₂ (nitrogen gas), NH₃ (ammonia), and the like may be directly introduced, or liquid B(CH₃)₃ (trimethylboron: TMB) may be introduced as a mixed gas by bubbling it with any carrier gas. Accordingly, the diamond coated tool of the present invention in which the base material surface is coated with the diamond layer containing predetermined amounts of boron and nitrogen can be manufactured.

### EXAMPLES

The present invention will be described in more detail with reference to Examples, which are not intended to limit the present invention.

While diamond layers are formed using a hot filament CVD method in the following, diamond layers may be formed using a conventionally known CVD method such as microwave plasma CVD or plasma jet CVD, for example.

In the fabrication of diamond coated tools according to Examples and Comparative Examples, an insert made of a material equivalent to the JIS K10-type cemented carbide (WC-6% Co) and having a shape equivalent to SPGN090308 (JIS B 4120: 1998) was used as the base material of the diamond coated tools.

Firstly, as a surface roughening treatment for a base material, the surface of the base material was sand-blasted with various SiC micropowders (average particle size: 4 to 100 µm). The spraying pressure was 0.15 to 0.35 MPa, and the irradiation time was 10 to 30 seconds. The base material was then immersed in 30 mass% nitric acid for 10 minutes to remove the Co on the base material surface. The base material after these treatments was measured for its surface roughness parameters Ra (arithmetic mean roughness) and RSm (mean length of roughness profile elements), using an optical laser microscope (product name: "LEXT OLS3500", manufactured by Olympus Corporation) (the results are shown in the "Base Material Ra" and "Base Material RSm" columns in Table 1).

A seeding treatment was subsequently performed to coat the surface of the base material with diamond powder. The seeding treatment was performed by rubbing the surface of the base material with diamond powder having an average particle size of 5 µm, and then washing the base material in ethanol, followed by drying. Next, the base material that underwent the seeding treatment described above was set in a known hot filament CVD apparatus. For the base material according to Example 1, at the time of forming a diamond layer, 3% by volume of CH₄ gas, as well as 0.1% by volume of N₂ gas and 0.05% by volume of B₂H₆ gas, in terms of the ratio between these gases and H₂ gas, were introduced into the CVD apparatus. The pressure was maintained at 1.3 × 10⁴ Pa with a gas flow rate and a pressure adjusting mechanism, and the temperature of the base material was adjusted to 850°C with a cooling mechanism for a base material holder. The filament temperature was set to 2080°C, and the film formation time for the diamond layer was 20 hours.

In the Examples and Comparative Examples except for Example 1, the gas mixture ratio, the pressure, the base material temperature, the filament temperature, and the film formation time were changed as desired, to adjust the thickness, the particle size, the boron density, the nitrogen density, and the residual compressive stress of the resulting diamond layer.

Diamond coated tools according to the Examples and Comparative Examples, each including a base material and a diamond layer coating the surface of the base material, were thus fabricated. X-ray diffraction using the θ/2θ method confirmed that all the fabricated diamond coated tools were coated with a polycrystal diamond. For the diamond coated tool according to Example 1, it was observed with a scanning electron microscope (SEM) that the base material was coated with a polycrystal diamond having a maximum particle size of 1.3 µm as the diamond layer, and the thickness of the coating was 11 µm from a cross-sectional observation. Elemental analysis of the surface of the diamond layer by SIMS confirmed that the diamond layer contained 4.5 × 10²⁰ atoms/cm³ of boron and 1.3 × 10¹⁹ atoms/cm³ of nitrogen. The residual compressive stress of the surface of the diamond layer measured by the sin²ψ method using a (311) diffraction line from the diamond was 1100 MPa. Results obtained for Examples 2 to 13 and Comparative Examples 1 to 7 as in Example 1 are shown in Table 1. In Table 1, "Diamond Layer Compressive Stress" represents the residual compressive stress of the surface of the diamond layer, "Diamond Maximum Particle Size" refers to the maximum particle size of diamond particles on the surface of the diamond layer, and "Diamond Layer Thickness" represents the thickness of the diamond layer.

**Table 1**

| | Boron Density (atoms/cm³) | Nitrogen Density (atoms/cm³) | Diamond Layer Compressive Stress (MPa) | Diamond Maximum Particle Size (µm) | Base Material Ra (µm) | Base Material RSm (µm) | Diamond Layer Thickness (µm) |
|---|---|---|---|---|---|---|---|
| Ex. 1 | 4.5 × 10²⁰ | 1.3 × 10¹⁹ | 1100 | 1.3 | 1.9 | 3.2 | 11 |
| Ex. 2 | 3.1 × 10¹⁹ | 1.1 × 10¹⁸ | 1850 | 1.4 | 4.8 | 45 | 16 |
| Ex. 3 | 2.8 × 10²¹ | 1.9 × 10¹⁹ | 830 | 0.5 | 0.41 | 2.1 | 3.2 |
| Ex. 4 | 2.8 × 10¹⁹ | 9.9 × 10¹⁷ | 1900 | 1.1 | 0.33 | 1.1 | 10 |
| Ex. 5 | 3.1 × 10²¹ | 1.1 × 10²⁰ | 700 | 2 | 0.15 | 1.3 | 28 |
| Ex. 6 | 1.1 × 10¹⁸ | 1.2 × 10¹⁷ | 2050 | 1.6 | 0.29 | 1.9 | 29 |
| Ex. 7 | 9.9 × 10²¹ | 9.8 × 10²⁰ | 780 | 0.19 | 0.11 | 1.2 | 0.3 |
| Ex. 8 | 3.2 × 10¹⁹ | 9.9 × 10¹⁹ | 810 | 2.1 | 3.9 | 9.8 | 0.9 |
| Ex. 9 | 2.8 × 10²¹ | 1.2 × 10¹⁸ | 1900 | 1.7 | 4.2 | 40 | 14 |
| Ex. 10 | 2.9 × 10¹⁹ | 1.2 × 10²⁰ | 790 | 0.08 | 5.1 | 52 | 23 |
| Ex. 11 | 3.3 × 10²¹ | 9.8 × 10¹⁷ | 2010 | 2.8 | 9.8 | 95 | 21 |
| Ex. 12 | 1.2 × 10¹⁸ | 9.6 × 10²⁰ | 510 | 0.06 | 4.8 | 53 | 9.5 |
| Ex. 13 | 9.6 × 10²¹ | 1.1 × 10¹⁷ | 2480 | 2.9 | 7.2 | 86 | 19 |
| Comp. Ex. 1 | 9.6 × 10¹⁷ | 9.8 × 10¹⁶ | 2150 | 3.1 | 0.29 | 1.9 | 29 |
| Comp. Ex. 2 | 1.1 × 10²² | 1.2 × 10²¹ | 490 | 0.07 | 0.11 | 1.2 | 0.3 |
| Comp. Ex. 3 | 9.9 × 10¹⁷ | 1.1 × 10²¹ | 400 | 0.04 | 0.09 | 0.9 | 0.09 |
| Comp. Ex. 4 | 1.2 × 10²² | 9.9 × 10¹⁶ | 2550 | 3.1 | 11 | 105 | 33 |
| Comp. Ex. 5 | 4.5 × 10²⁰ | 8.5 × 10¹⁶ (Measurement Lower Limit) or Below | 2600 | 4.5 | 1.9 | 3.2 | 11 |
| Comp. Ex. 6 | 5.1 × 10¹⁵ (Measurement Lower Limit) or Below | 1.3 × 10¹⁹ | 490 | 0.04 | 1.9 | 3.2 | 11 |
| Comp. Ex. 7 | 5.1 × 10¹⁵ (Measurement Lower Limit) or Below | 8.5 × 10¹⁶ (Measurement Lower Limit) or Below | 1350 | 2.8 | 1.9 | 3.2 | 11 |

Next, with each of the diamond coated tools according to Examples 1 to 13 and Comparative Examples 1 to 7 fabricated as above, wet interrupted cutting was performed to evaluate the adhesion of the diamond layer and chipping resistance.

Cutting conditions were as follows: a round bar made of ADC12 (12% Si-Al alloy) having six grooves running in an axial direction was used as a workpiece, and machining was performed at a cutting speed of 500 m/min, a cutting depth of 0.4 mm, and a feed rate of 0.1 mm/rev. As a form of damage of the diamond layer, the amount of wear of a flank face after 40 minutes of machining was evaluated, and the machining time until chipping or film peel-off (peel-off of the diamond layer) occurred was also evaluated. The smaller the numerical value of the amount of wear of the flank face was, or the longer the machining time until chipping or film peel-off occurred was, the longer the tool lifetime became owing to the improvement of the oxidation resistance and the defect resistance. The results are shown in Table 2.

**Table 2**

| | Amount of Wear (mm) of Flank Face after 40 Minutes of Machining | Machining Time (Min) Until Chipping or Film Peel-off Occurred | Form of Damage |
|---|---|---|---|
| Ex. 1 | 0.020 | 120 | Film Peel-off |
| Ex. 2 | 0.022 | 110 | Film Peel-off |
| Ex. 3 | 0.019 | 40 | Film Peel-off |
| Ex. 4 | 0.024 | 100 | Film Peel-off |
| Ex. 5 | 0.018 | 90 | Chipping |
| Ex. 6 | 0.038 | 80 | Chipping |
| Ex. 7 | 0.038 | 20 | Film Peel-off |
| Ex. 8 | 0.036 | 20 | Film Peel-off |
| Ex. 9 | 0.017 | 90 | Film Peel-off |
| Ex. 10 | 0.025 | 100 | Film Peel-off |
| Ex. 11 | 0.024 | 80 | Film Peel-off |
| Ex. 12 | 0.028 | 70 | Film Peel-off |
| Ex. 13 | 0.015 | 60 | Chipping |
| Comp. Ex. 1 | 0.044 | 40 | Chipping |
| Comp. Ex. 2 | 0.066 | 5 | Film Peel-off |
| Comp. Ex. 3 | 0.083 | 5 | Film Peel-off |
| Comp. Ex. 4 | 0.042 | 20 | Chipping |
| Comp. Ex. 5 | 0.255 | 10 | Chipping |
| Comp. Ex. 6 | 0.193 | 10 | Film Peel-off |
| Comp. Ex. 7 | 0.039 | 80 | Film Peel-off |

As shown in Table 2, in each of Examples 1 to 13, since the densities of boron and nitrogen in the diamond layer were appropriately controlled, a lengthened tool lifetime was observed in a range of thicknesses of the diamond layer practical as a tool, as compared to Comparative Examples 1 to 4. Comparative Examples 5 to 7 correspond to the case where nitrogen was not added, the case where boron was not added, and the case where both nitrogen and boron were not added, respectively, for comparison with Example 1. Each of these cases resulted in a lifetime shorter than that of Example 1, due to chipping caused by an increase in stress and deterioration of wear resistance, which demonstrated the effects of the present invention.

While the embodiments and examples of the present invention have been described as above, it is originally contemplated to combine, as appropriate, features of each of the foregoing embodiments and examples.

It should be understood that the embodiments and examples disclosed herein are illustrative and non-restrictive in every respect. The scope of the present invention is defined by the terms of the claims, rather than by the foregoing description, and is intended to include any modifications within the scope and meaning equivalent to the terms of the claims.

## Claims

1. A diamond coated tool comprising:
a base material; and
a diamond layer coating a surface of said base material,
said diamond layer containing a diamond, 1.0 × 10¹⁸ to 1.0 × 10²² atoms/cm³ of boron, and 1.0 × 10¹⁷ to 1.0 × 10²¹ atoms/cm³ of nitrogen.

2. The diamond coated tool according to claim 1, wherein
said diamond layer has a residual compressive stress of 500 to 2500 MPa on a surface thereof according to X-ray stress measurement.

3. The diamond coated tool according to claim 1 or 2, wherein
said diamond layer has a maximum particle size of 0.05 to 3 µm of diamond particles on said surface thereof.

4. The diamond coated tool according to any of claims 1 to 3, wherein said diamond layer contains 3.0 × 10¹⁹ to 3.0 × 10²¹ atoms/cm³ of boron.

5. The diamond coated tool according to any of claims 1 to 4, wherein said diamond layer contains 1.0 × 10¹⁸ to 1.0 × 10²⁰ atoms/cm³ of nitrogen.

6. The diamond coated tool according to any of claims 1 to 5, wherein said diamond layer has a residual compressive stress of 800 to 2000 MPa on said surface thereof according to X-ray stress measurement.

7. The diamond coated tool according to any of claims 1 to 6, wherein said base material is made of a cemented carbide.

8. The diamond coated tool according to any of claims 1 to 7, wherein said surface of said base material has an arithmetic mean roughness Ra of 0.1 to 10 µm and a mean length RSm of roughness profile elements of 1 to 100 µm.

9. The diamond coated tool according to any of claims 1 to 8, wherein said diamond layer has a thickness of 0.1 to 30 µm.
